# FASCICULE DE BREVET EUROPEEN

(11) **EP 4 354 279 B1**
(45) Date de publication et mention de la délivrance du brevet: **05.03.2025**
(21) Numéro de dépôt: 23201926.5
(22) Date de dépôt: 05.10.2023
(51) Int. Cl.: G06F 7/58

(54) **GENERATION DE NOMBRES VRAIMENT ALEATOIRES A ECHANTILLONNAGE COHERENT EN TECHNOLOGIE FD-SOI**
ERZEUGUNG VON ECHTEN ZUFALLSZAHLEN MIT KOHÄRENTER ABTASTUNG IN FD-SOI-TECHNOLOGIE
GENERATION OF TRUE RANDOM NUMBERS WITH COHERENT SAMPLING IN FD-SOI TECHNOLOGY

(30) Priorité: 14.10.2022 FR 2210593
(43) Date de publication de la demande: 17.04.2024
(73) Titulaire: Commissariat à l'Energie Atomique et aux Energies Alternatives, 75015 Paris (FR)
(72) Inventeur: BENEA, Licinius-Pompiliu, 38054 GRENOBLE CEDEX 09 (FR); PEBAY-PEYROULA, Florian, 38054 GRENOBLE CEDEX 09 (FR); CARMONA, Mikaël, 38054 GRENOBLE CEDEX 09 (FR); WACQUEZ, Romain, 38054 GRENOBLE CEDEX 09 (FR)
(74) Mandataire: Cabinet Beaumont

(56) Documents cités:
- PEETERMANS ADRIAAN ET AL: "Design and Analysis of Configurable Ring Oscillators for True Random Number Generation Based on Coherent Sampling", vol. 14, no. 2, 30 June 2021 (2021-06-30), US, pages 1 - 20, XP093048724, ISSN: 1936-7406, Retrieved from the Internet <URL:https://www.esat.kuleuven.be/cosic/publications/article-3280.pdf> DOI: 10.1145/3433166
- V FISCHER ET AL: "Project ANR -ICTeR True Random Number Generators in Configurable Logic Devices Version 1.02", 12 February 2009 (2009-02-12), pages 0 - 58, XP055102465, Retrieved from the Internet <URL:http://www.lirmm.fr/~w3mic/ANR/PDF/D2.pdf> [retrieved on 20140217]
- PAUL KOHLBRENNER ET AL: "An embedded true random number generator for FPGAs", FPGA 2004. ACM/SIGDA 12TH. ACM INTERNATIONAL SYMPOSIUM ON FIELD- PROGRAMMABLE GATE ARRAYS. MONTEREY, CA, FEB. 22 - 24, 2004; [ACM/SIGDA INTERNATIONAL SYMPOSIUM ON FIELD PROGRAMMABLE GATE ARRAYS], ACM, NEW YORK, US, 22 February 2004 (2004-02-22), pages 71 - 78, XP058348831, ISBN: 978-1-58113-829-0, DOI: 10.1145/968280.968292

## Description

### Domaine technique

La présente description concerne de façon générale les circuits électroniques, et, plus particulièrement, les circuits de génération de nombres aléatoires.

### Technique antérieure

De nombreux systèmes électroniques mettent en œuvre des fonctionnalités ou des applications, par exemple des primitives cryptographiques (génération de clés de session, signature numériques, masquages, etc), utilisant des nombres aléatoires. Pour cela, ces systèmes électroniques comprennent un circuit de génération de nombres aléatoires, aussi appelé plus simplement générateur de nombres aléatoires (RNG de l'anglais "Random Number Generator"). Un générateur de nombres aléatoires comprend un circuit de génération de nombres vraiment aléatoires, aussi appelé plus simplement générateur de nombres vraiment aléatoires (TRNG de l'anglais "True RNG"). L'imprédictibilité des nombres aléatoires générés permet, par exemple, d'assurer l'imprédictibilité des sorties d'une primitive cryptographique de sorte à garantir le niveau de sécurité de cette primitive.

Les générateurs de nombres vraiment aléatoires s'appuient sur un ou plusieurs phénomènes physiques pour générer l'aléa à partir duquel sont générés les nombres aléatoires, ces phénomènes physiques étant par exemple des radiations, du bruit de phase, des phénomènes optiques, etc.

La présente description s'intéresse plus particulièrement aux générateurs de nombres vraiment aléatoires basés sur des oscillateurs en anneau, l'aléa résultant alors de la gigue d'horloge ("jitter" en anglais), c'est à dire de l'écart entre la période théorique d'un oscillateur en anneau et la période réelle ou effective de cet oscillateur.

Plusieurs types de générateur de nombres vraiment aléatoires basés sur des oscillateurs en anneau sont connus, par exemple les générateurs de nombres vraiment aléatoires à oscillateur en anneau élémentaire (ERO TRNG de l'anglais "Elementary Ring Oscillator TRNG"), les générateurs de nombres vraiment aléatoires à multiples oscillateurs en anneaux (MURO TRNG de l'anglais "Multiple Ring Oscillators TRNG"), les générateurs de nombre vraiment aléatoires à anneau auto chronométré (STR TRNG de l'anglais "Self Timed Ring TRNG"), les générateurs de nombres vraiment aléatoires à oscillateur en anneau à effet de transition (TERO TRNG de l'anglais "Transition Effect Ring Oscillator TRNG") et les générateurs de nombres vraiment aléatoires à oscillateurs en anneau à échantillonnage cohérent (COSO TRNG de l'anglais "COherent Sampling ring Oscillators TRNG").

Les générateurs de nombres vraiment aléatoires de type COSO présentent les avantages suivants : une mise en œuvre plus simple que celles des générateurs de type MURO TRNG, un débit de sortie plus élevé que celui des générateurs de type ERO TRNG, et une consommation plus faible que celle des générateurs de type STR TRNG.

Toutefois, les générateurs de nombres vraiment aléatoires connus de type COSO TRNG présentent divers inconvénients.

### Résumé de l'invention

Il existe un besoin d'un circuit de génération de nombres vraiment aléatoires à oscillateurs en anneau à échantillonnage cohérent qui pallie tout ou partie des inconvénients des circuits connus de génération de nombres vraiment aléatoires à oscillateurs en anneau à échantillonnage cohérent, par exemple en ce qui concerne le réglage de la fréquence des oscillateurs en anneaux du circuit de génération de nombres vraiment aléatoires à oscillateurs en anneau à échantillonnage cohérent.

Un mode de réalisation pallie tout ou partie des inconvénients des circuits connus de génération de nombres vraiment aléatoires à oscillateurs en anneau à échantillonnage cohérent.

Un mode de réalisation prévoit un circuit de génération de nombres aléatoires de type à oscillateur en anneau à échantillonnage corrélé comprenant :
un premier oscillateur en anneau et un deuxième oscillateur en anneau comprenant chacun des éléments à retard connectés en série en boucle fermée, les premier et deuxième oscillateurs étant identiques et mis en œuvre en technologie Métal Oxyde Semiconducteur Complémentaire sur silicium sur isolant complétement déplété ;
un premier circuit configuré pour échantillonner et mémoriser l'état d'une sortie du premier oscillateur à une fréquence d'une sortie du deuxième oscillateur et pour fournir un signal binaire correspondant ; et
un deuxième circuit configuré pour commander des grilles arrière de transistors PMOS et NMOS d'au moins un élément à retard d'au moins un des premier et deuxième oscillateurs, sur la base d'un écart de période entre les sorties des premier et deuxième oscillateurs.

Selon un mode de réalisation, la commande des grilles arrière desdits transistors PMOS et NMOS dudit au moins un élément à retard est configurée pour augmenter une fréquence du premier oscillateur par rapport à une fréquence du deuxième oscillateur lorsque la période de la sortie du premier oscillateur est plus faible que la période de la sortie du deuxième oscillateur, et pour diminuer la fréquence premier oscillateur par rapport à la fréquence du deuxième oscillateur lorsque la période de la sortie du premier oscillateur est plus grande que la période de la sortie du deuxième oscillateur.

Selon un mode de réalisation, le deuxième circuit est configuré pour commander les grilles arrière desdits transistors PMOS et NMOS dudit au moins un élément à retard de sorte à réduire l'écart de période.

Selon un mode de réalisation, le deuxième circuit est configuré pour commander les grilles arrière desdits transistors PMOS et NMOS dudit au moins un élément à retard de sorte que l'écart de période soit au moins N fois plus faible que la période du deuxième oscillateur, avec N un nombre déterminé pour qu'une contribution du bruit thermique soit prépondérante devant une contribution du bruit de quantification dans la gigue de la sortie du deuxième oscillateur.

Selon un mode de réalisation, N est supérieur ou égal à 1000, par exemple égal à 1000.

Selon un mode de réalisation, le deuxième circuit comprend un compteur configuré pour compter, à une fréquence de la sortie du deuxième oscillateur, un nombre de fois où ledit signal binaire est à un premier état binaire pendant une durée de N périodes de la sortie du deuxième oscillateur.

Selon un mode de réalisation, ladite durée est une durée glissante.

Selon un mode de réalisation, le deuxième circuit comprend en outre un comparateur configuré pour comparer ledit nombre à une valeur égale à N/2.

Selon un mode de réalisation, le deuxième circuit est configuré pour commander les grilles arrière desdits transistors PMOS et NMOS dudit au moins un élément à retard à partir d'un signal de sortie du comparateur indiquant le résultat de ladite comparaison.

Selon un mode de réalisation, le deuxième circuit comprend un détecteur de fréquence de phase configuré pour recevoir les sorties des premier et deuxième oscillateurs.

Selon un mode de réalisation, le circuit de génération de nombres aléatoires comprend au moins une pompe de charge commandée par le détecteur de fréquence de phase et configurée pour charger et décharger une capacité connectée à une sortie de ladite au moins une pompe de charge, une tension de commande des grilles arrière desdits transistors PMOS et NMOS dudit au moins un élément à retard étant disponible aux bornes de la capacité.

Selon un mode de réalisation, le deuxième circuit est configuré pour commander la grille arrière de chacun des transistors PMOS et NMOS d'un seul des premier et deuxième oscillateurs.

Selon un mode de réalisation, le deuxième circuit est configuré pour fournir une même première tension à la grille arrière de chacun des transistors PMOS dudit un seul des premier et deuxième oscillateurs, et une même deuxième tension à la grille arrière de chacun des transistors NMOS dudit un seul des premier et deuxième oscillateurs.

Selon un mode de réalisation, le deuxième circuit est configuré pour commander la grille arrière de chacun des transistors de chacun des premier et deuxième oscillateurs.

Selon un mode de réalisation, le deuxième circuit est configuré pour fournir une même première tension à la grille arrière de chacun des transistors PMOS du premier oscillateur, une même deuxième tension à la grille arrière de chacun des transistors NMOS du premier oscillateur, une même troisième tension à la grille arrière de chacun des transistors PMOS du deuxième oscillateur, et une même quatrième tension à la grille arrière de chacun des transistors NMOS du deuxième oscillateur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme de blocs, un exemple de circuit de génération de nombres aléatoires à oscillateurs en anneau à échantillonnage cohérent ;
la figure 2 représente, sous la forme de blocs, un mode de réalisation d'un circuit de génération de nombres aléatoires à oscillateurs en anneau à échantillonnage cohérent ;
la figure 3 représente, sous la forme de blocs, une variante de réalisation du circuit de génération de nombres aléatoires de la figure 1 ; et
la figure 4 représente, sous la forme de blocs, un autre mode de réalisation d'un circuit de génération de nombres aléatoires à oscillateurs en anneau à échantillonnage cohérent.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Il est connu de la personne du métier qu'un circuit de génération de nombre aléatoire comprend généralement un circuit de génération de nombres vraiment aléatoire, qui comprend une source d'entropie (ou d'aléa), et un circuit de traitement connecté en sortie du circuit de génération de nombres vraiment aléatoires et configuré pour augmenter le débit de la source d'aléa échantillonnée, le circuit de traitement comprenant couramment un circuit de génération de nombres pseudo aléatoires (PRNG de l'anglais "Pseudo Random Number Generator"). La suite de la présente description concerne plus particulièrement un circuit de génération de nombres vraiment aléatoires, et, encore plus particulièrement, la source d'entropie échantillonnée de ce circuit. Par souci de clarté, seuls les étapes et éléments utiles à la compréhension des modes de réalisation décrits ont été représentés et sont détaillés. En particulier, les circuits de traitement connus destinés à augmenter le débit d'une source d'aléa échantillonnée, les circuits usuels ou les applications usuelles comprenant un circuit de génération de nombres vraiment aléatoires n'ont pas été décrits ou détaillés, les modes de réalisation et variantes de la source d'entropie échantillonnée, ou source d'aléa physique échantillonnée, décrits étant compatibles avec ces circuits de traitement usuels, et avec ces circuits et applications usuels comprenant un circuit de génération de nombres vraiment aléatoires.

Dans la suite de la description, les expressions "circuit de génération de nombres vraiment aléatoires" et "générateur de nombres vraiment aléatoires" désignent indifféremment un circuit de génération de nombres vraiment aléatoires ou un circuit de génération de nombres aléatoires comprenant un circuit de génération de nombres vraiment aléatoires.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

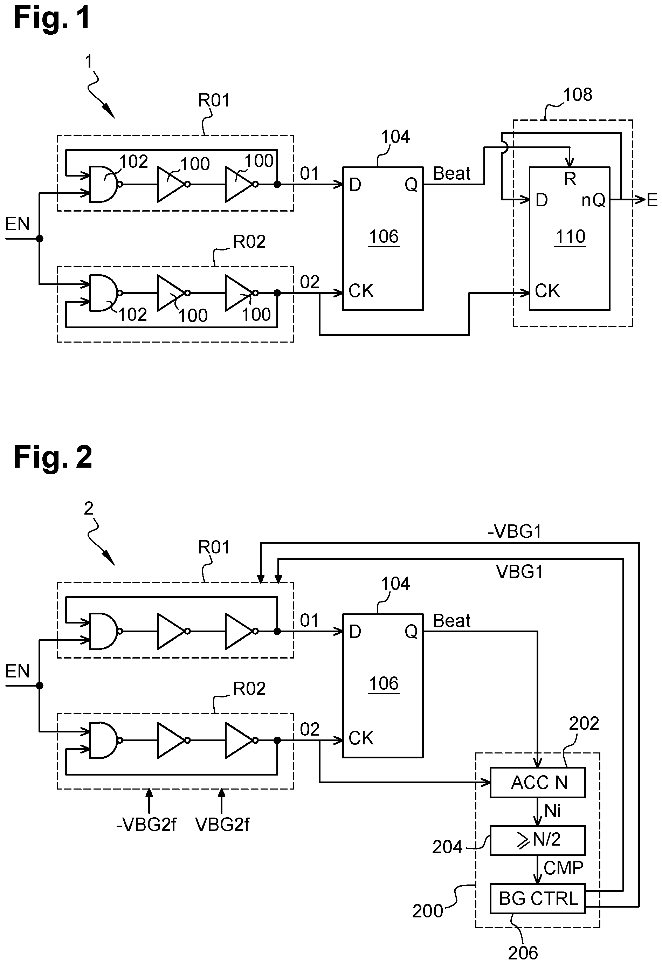

La figure 1 représente, sous la forme de blocs, un exemple d'un circuit 1 de génération de nombres vraiment aléatoires à oscillateurs en anneau à échantillonnage cohérent (COSO TRNG), et, plus particulièrement, une partie seulement de la source d'entropie échantillonnée du circuit 1.

Le circuit 1 comprend deux oscillateurs en anneau RO1 et RO2. Les deux oscillateurs RO1 et RO2 sont identiques, c'est à dire qu'ils comprennent les mêmes éléments à retard connectés en série dans une boucle fermée (ou anneau) comprenant un nombre impair de fonctions inverseuses. Chacun des oscillateurs RO1 et RO2 reçoit, par exemple, un signal EN dont un premier état binaire permet de fermer la boucle de l'oscillateur de sorte à activer l'oscillateur pour que des oscillations se propagent dans l'oscillateur, et dont un deuxième état binaire permet d'ouvrir la boucle de l'oscillateur de sorte à désactiver l'oscillateur pour stopper la propagation des oscillations dans l'oscillateur.

A titre d'exemple, comme cela est illustré en figure 1, chaque oscillateurs RO1, RO2 comprend un même nombre pair d'inverseurs 100 en série entre une sortie d'une porte NON-ET 102 et une entrée de la porte 102, l'autre entrée de la porte 102 recevant le signal EN.

Les deux oscillateurs RO1 et RO2 fournissent deux signaux en créneaux périodiques respectifs O1 et O2. Du fait que les oscillateurs RO1 et RO2 sont identiques, les deux signaux O1 et O2 ont, au moins en théorie, des fréquences identiques. La fréquence des signaux O1 et O2 dépend du retard introduit par chaque élément à retard 100, 102 connecté en série dans les boucles des oscillateurs respectifs RO1 et RO2.

Le circuit 1 comprend en outre un circuit 104 configuré pour échantillonner et mémoriser l'état de la sortie O1 de l'oscillateur RO1, à la fréquence de la sortie O2 de l'oscillateur RO2, c'est à en synchronisme avec la sortie O2. Dit autrement, à chaque front d'un premier type, par exemple montant, du signal O2, le circuit 104 est configuré pour mettre à jour l'état binaire d'un signal binaire de sortie Beat du circuit 104 à partir, ou en fonction, de l'état binaire du signal O1, puis pour maintenir cet état binaire mis à jour du signal Beat jusqu'au prochain front du premier type du signal O2. Dit encore autrement, le signal Beat est synchrone au signal O2.

Dans l'exemple de la figure 1, le circuit 104 est mis en œuvre par une bascule D ("D flip-flop" en anglais), référencée 106 en figure 1. La bascule 106 comprend une entrée de donnée D recevant le signal O1, une entrée de synchronisation CK recevant le signal O2 et, dans l'exemple de la figure 1, une sortie Q fournissant le signal Beat mis à jour avec l'état binaire du signal O1 à chaque front du premier type du signal O2. Dans un autre exemple, la bascule 106 comprend une sortie nQ fournissant le signal Beat mis à jour avec le complémentaire de l'état binaire du signal O1 à chaque front du premier type du signal O2, c'est à dire avec un état binaire bas lorsque le signal O1 est à l'état haut et avec un état binaire haut lorsque le signal O1 est à l'état bas.

Le signal Beat oscille entre ses deux états binaires, c'est à dire entre son premier état binaire et son deuxième état binaire selon que le signal O1 soit en avance de phase ou en retard de phase par rapport à O2. Dit autrement, le signal Beat est l'image de l'écart de phase entre les signaux O1 et O2. Dit encore autrement, le signal Beat indique le signe de l'écart de phase entre les signaux O1 et O2. Du fait que cet écart de phase dépend de la gigue aléatoire de chacun des oscillateurs RO1 et RO2, l'aléa physique utilisé dans le circuit 1 est le bruit de phase et le signal Beat est l'image de ce bruit de phase. C'est ce signal Beat qui est ensuite utilisé pour générer un nombre vraiment aléatoire. Par exemple, c'est la longueur (ou durée) de l'un des états binaires du signal Beat, par exemple son état haut, qui est ensuite utilisé pour générer un nombre vraiment aléatoire. A titre d'exemple, dans le circuit 1, une petite différence entre les périodes des deux oscillateurs RO1 et RO2 modifie la période du signal Beat, et les nombres aléatoires sont générés par les variations de la période du signal Beat, la phase entre les signaux O1 et O2 étant, par exemple, en constante évolution entre -Π/2 et Π/2.

Dans l'exemple de la figure 1, le signal Beat est fourni à un circuit 108 du circuit 1. Le circuit 108 est configuré pour recevoir le signal Beat et le signal O2 et pour fournir, à partir des signaux Beat et O2 reçus, un signal aléatoire de sortie E.

A titre d'exemple non illustré, le circuit 108 peut comprendre un compteur configuré pour s'incrémenter à la fréquence du signal O2, par exemple à chaque front d'un premier type du signal O2, lorsque le signal Beat est dans un premier état binaire, par exemple l'état bas, et pour être réinitialisé quand le signal Beat est dans un deuxième état binaire, par exemple l'état haut. Dit autrement, ce compteur mesure, en nombre de périodes du signal O2, la durée pendant laquelle le signal Beat reste à son premier état binaire. Le compteur est, par exemple, suivi d'un circuit sélectionnant le bit de poids faible du signal de sortie du compteur, ce bit de poids faible étant de préférence rééchantillonné à la fréquence du signal Beat pour assurer la stabilité et correspondant au signal aléatoire de sortie E du circuit 108.

Dans l'exemple de la figure 1, le compteur du circuit 108 est mis en œuvre par une bascule D, référencée 110 en figure 1, configurée pour correspondre fonctionnellement à garder le bit de poids faible du compteur décrit dans l'exemple précédant. Par exemple, la bascule 110 a son entrée de donnée D connectée à sa sortie nQ, son entrée de synchronisation CK connectée au signal O2 et une entrée de réinitialisation R recevant le signal Beat. La sortie nQ de la bascule 110, de préférence rééchantillonnée à la fréquence du signal Beat pour assurer la stabilité, correspond alors au signal aléatoire de sortie E du circuit 108. Dans un autre exemple non illustré, c'est la sortie Q de la bascule 110 qui est connectée à l'entrée D de la bascule 110.

La personne du métier est en mesure de prévoir d'autres exemples de circuit 108.

En pratique, pour que le circuit 1 fournisse un signal E réellement aléatoire, c'est à dire pour que le circuit 1 soit un circuit de génération de nombres vraiment aléatoires, l'écart de période entre les signaux O1 et O2, c'est à dire l'écart entre la période du signal O1 et celle du signal O2, doit être très faible devant la période de ces signaux, et en particulier devant la période du signal O2 qui cadence les mémorisations.

La personne du métier est en mesure de déterminer ce que signifie ici le terme très faible. Par exemple, la personne du métier est en mesure de déterminer une valeur maximale que l'écart de période ne devrait pas dépasser pour que la précision avec laquelle est mesurée la gigue d'horloge soit satisfaisante, c'est à dire pour que la résolution du signal Beat soit suffisante pour mesurer la gigue d'horloge du signal O2 qui est, par exemple, environ trois ordres de grandeur plus faible que la période du signal O2.

Par exemple, les inventeurs ont montré en utilisant la variance d'Allan qu'il est souhaitable que l'écart maximal de période entre les signaux O1 et O2 soit N fois plus faible que la période du signal O2, donc que la période des signaux O1 et O2 soit N fois plus petite que la période du signal Beat, avec N un nombre déterminé pour que la contribution du bruit thermique soit prépondérante par rapport à la contribution du bruit de quantification, par exemple pour que le bruit thermique soit au moins dix fois plus élevé que le bruit de quantification, dans la gigue du signal O2. A titre d'exemple, N est supérieur ou égal à 1000, par exemple égale à 1000.

Dit autrement, lorsque l'écart maximal entre les périodes des signaux O1 et O2 est N fois plus faible que la période du signal O2, la résolution du signal Beat est de 1/N et, pour mesurer à l'aide du signal Beat une gigue du signal O2 dans laquelle la contribution du bruit thermique soit prépondérante devant la contribution du bruit de quantification, N est, par exemple, choisi supérieur ou égal à 1000, par exemple égal à 1000.

Pour assurer que l'écart de période entre les signaux O1 et O2 est très faible devant la période des signaux O1 et O2, il existe des oscillateurs en anneau ayant des structures reconfigurables mises en œuvre sur FPGA (de l'anglais "Field Programmable Gate Array" - réseau de portes programmables). Toutefois, ces structures d'oscillateurs en anneau reconfigurables sont encombrantes.

Pour assurer que l'écart de période entre les signaux O1 et O2 est très faible devant la période des signaux O1 et O2, il existe également des oscillateurs en anneau comprenant des capacités à valeur réglable commandable en entrée de chaque élément à délai de ces oscillateurs. Toutefois, les plages de valeurs que peuvent prendre ces capacités variables et le placement routage de chaque oscillateur devront être adaptés à chaque changement de technologie, ce qui n'est pas souhaitable. Par ailleurs, l'introduction de ces capacités variables augmente l'encombrement et/ou la consommation du circuit 1.

Selon un mode de réalisation, il est proposé un circuit 2 de génération de nombres vraiment aléatoires similaire au circuit 1 décrit ci-dessus, dans lequel les oscillateurs RO1 et RO2 sont mis en œuvre en technologie métal oxide semiconducteur complémentaire (CMOS de l'anglais "Complementary Metal Oxide Semiconductor") et sur silicium sur isolant complètement déplété (FDSOI de l'anglais "Fully Depleted Silicon on Insulator"), et dans lequel les grilles arrière de transistors PMOS (transistor MOS à canal P) et NMOS (transistor MOS à canal N) d'au moins un élément à retard d'au moins un des oscillateurs RO1 et RO2 est commandée par un circuit de commande (ou de calibration) 200 du circuit 2.

En commandant les grilles arrière de transistors PMOS et NMOS d'au moins l'un des éléments à retard des oscillateurs RO1 et RO2, il est alors possible de modifier les fréquences des oscillateurs RO1 et RO2 l'une par rapport à l'autre, de sorte à réduire l'écart de période entre les signaux O1 et O2 jusqu'à des valeurs très faibles devant les périodes des signaux O1 et O2. A titre d'exemple, lorsqu'un élément à retard de l'oscillateur en anneau RO1 ou RO2 a des transistors PMOS et NMOS ayant des grilles arrière commandées par le circuit de commande 200, ces transistors PMOS et NMOS de l'élément à retard comprennent au moins les transistors PMOS et NMOS de l'élément à retard qui ont leurs grilles avant connectées à la sortie de l'élément à retard précédant dans l'oscillateur en anneau.

La modification des fréquences des oscillateurs RO1 et RO2 en commandant les grilles arrière de transistors PMOS et NMOS d'au moins l'un des éléments à retard des oscillateurs RO1 et RO2 pour obtenir un écart de périodes entre les signaux O1 et O2 inférieur à une valeur visée est plus précise que si la modification des fréquences des oscillateurs RO1 et RO2 était mise en œuvre grâce à une méthode de privation de courant ("current starving" en anglais).

Selon un mode de réalisation, lorsqu'un élément à retard de l'oscillateur en anneau RO1 ou RO2 a des transistors PMOS et NMOS ayant des grilles arrière commandées par le circuit de commande 200, la commande de ces grilles arrière par le circuit 200 est basée sur l'écart de période entre les signaux O1 et O2. Par exemple, le circuit 200 est alors en mesure d'obtenir une indication de la valeur courante de l'écart de période entre les signaux O1 et O2, par exemple à partir du signal Beat ou à partir des signaux O1 et O2 directement, bien que la personne du métier soit en mesure de prévoir d'autres façons d'obtenir cette indication.

Selon un mode de réalisation, la commande de la grille arrière de transistors PMOS et NMOS d'au moins un élément à retard d'au moins un des oscillateurs RO1 et RO2 par le circuit 200 est configurée pour réduire l'écart de période entre les signaux O1 et O2, par exemple jusqu'à une valeur inférieure ou égale à une valeur visée, cette valeur visée d'écart entre les périodes des signaux O1 et O2 étant par exemple N fois plus faible que la période du signal O2, avec N déterminé pour que, dans la gigue du signal O2, la contribution du bruit de quantification soit négligeable, par exemple au moins dix fois plus faible, devant la contribution du bruit thermique qui est la source d'entropie. A titre d'exemple, N est supérieur ou égal à 1000, par exemple égal à 1000.

Plus particulièrement, selon un mode de réalisation, le circuit 200 est configuré pour commander la grille arrière de transistors PMOS et NMOS d'au moins un élément à retard des oscillateurs RO1 et RO2 de sorte que :
la fréquence de l'oscillateur RO1 diminue par rapport à celle de l'oscillateur RO2 quand la fréquence du signal O1 est plus rapide que celle du signal O2, c'est à dire que :
   - la fréquence de l'oscillateur RO1 soit réduite alors que celle de l'oscillateur RO2 reste inchangée, ou
   - la fréquence de l'oscillateur RO1 soit réduite et, dans le même temps, celle de l'oscillateur RO2 soit augmentée, ou
   - la fréquence de l'oscillateur RO2 soit augmentée alors que celle de l'oscillateur RO1 reste inchangée ; et
la fréquence de l'oscillateur RO1 augmente par rapport à celle de l'oscillateur RO2 quand la fréquence du signal O1 est plus faible que celle du signal O2, c'est à dire que :
   - la fréquence de l'oscillateur RO1 soit augmentée alors que celle de l'oscillateur RO2 reste inchangée, ou
   - la fréquence de l'oscillateur RO1 soit augmentée et, dans le même temps, celle de l'oscillateur RO2 soit réduite, ou
   - la fréquence de l'oscillateur RO2 soit réduite alors que celle de l'oscillateur RO1 reste inchangée.

Selon un mode de réalisation, une indication de la valeur courante de l'écart de période entre les signaux O1 et O2 est obtenu en mesurant, en nombre de périodes du signal O2, la période du signal Beat, et le réglage du circuit 1 consiste alors à régler la période des signaux O1 et O2 pour que la période du signal Beat soit égale à N périodes du signal O2. Pour cela, on peut prévoir un circuit, ou compteur, configuré pour compter, à la fréquence du signal O2, un nombre de fois où le signal Beat est dans un état binaire donné pendant une durée de N périodes du signal O2. De préférence, cette durée de N périodes du signal O2 est une durée glissante. Dit autrement, le compteur est configuré pour mesurer, en nombre de périodes du signal O2, la demi-période du signal Beat.

Selon un autre mode de réalisation, pour obtenir une indication de la valeur courante de l'écart de période entre les signaux O1 et O2, le circuit 200 comprend un détecteur de fréquence de phase configuré pour recevoir les signaux O1 et O2.

Des exemples de modes de réalisation d'un tel circuit 2 vont maintenant être décrits.

La figure 2 représente, sous la forme de blocs, un exemple de mode de réalisation d'un circuit 2.

Le circuit 2 comprend de nombreux éléments en commun avec le circuit 1, et seules les différences entre ces deux circuits 1 et 2 sont ici mises en exergue. En outre, en figure 2, le circuit 108 n'est pas représenté pour ne pas surcharger la figure.

Dans ce mode de réalisation, le circuit 200 du circuit 2 obtient une indication de la valeur courante de l'écart de période entre les signaux O1 et O2 à partir du signal Beat et d'un compteur 202 (bloc "ACC N") cadencé à la fréquence du signal O2. Par exemple, le compteur 202 est synchronisé sur les fronts du premier type du signal O2, par exemple les fronts montants. Le compteur 202 du circuit 2 est configuré pour compter, à la fréquence du signal O2, le nombre de fois où, pendant une durée, de préférence glissante, de N périodes du signal O2, le signal Beat est dans un état binaire donné, par exemple l'état haut. Le compteur 202 reçoit donc les deux signaux Beat et O2, et fournit un signal Ni de sortie indiquant le nombre compté.

Le signal ou nombre Ni est représentatif de la valeur courante, en nombre de périodes du signal O2, de la demi-période du signal Beat, donc de la période du signal Beat, et donc de l'écart de période entre les signaux O1 et O2. En comptant le nombre Ni pendant une durée, de préférence glissante, de N périodes du signal O2, si les périodes des signaux O1 et O2 sont suffisamment proches pour permettre la génération de nombres vraiment aléatoires, par exemple si l'écart de période entre les signaux O1 et O2 est au moins N fois plus faible que la période du signal O2, alors le nombre Ni devrait être égal à N/2 (demi-période du signal Beat égal à N/2 périodes du signal O2 et période du signal Beat égal à N périodes du signal O2). En revanche, si ce n'est pas le cas, par exemple si l'écart de période entre les signaux O1 et O2 n'est pas N fois plus faible que la période des signaux O1 et O2, alors le nombre Ni devrait être différent de N/2.

A titre d'exemple, comme cela est illustré en figure 2 :
- le circuit 104 est synchronisé sur les fronts montants du signal O2,
- le signal Beat est mis à jour avec l'état binaire du signal O1,
- le circuit 202 est synchronisé sur les fronts montants du signal O2, et
- le circuit 202 compte le nombre Ni de fois où le signal Beat est à l'état haut pendant une durée, de préférence glissante, de N périodes du signal O2. Dans cet exemple particulier, le nombre Ni est supérieur à N/2 si la fréquence du signal O1 est supérieure à celle du signal O2 et que l'écart entre les périodes des signaux O2 et O2 n'est pas N fois plus faible que la période des signaux O1 et O2, et est inférieur à N/2 si la fréquence du signal O1 est inférieure à celle du signal O2 et que l'écart entre les périodes des signaux O2 et O2 n'est pas N fois plus faible que la période des signaux O1 et O2.

Selon un mode de réalisation, le circuit 200 comprend un circuit, ou comparateur, 204 (bloc "≥N/2") configuré pour comparer la sortie Ni du compteur 202 à la valeur N/2. Le circuit 204 fournit un signal CMP indiquant le résultat de cette comparaison. A titre d'exemple, le signal CMP est un signal binaire ayant un premier état indiquant que Ni est inférieur à N/2 et un deuxième état indiquant que Ni est supérieur ou égal à N/2.

Le circuit 200 est alors configuré pour commander les grilles arrière de transistors PMOS et NMOS d'au moins un élément à retard d'au moins un des oscillateur RO1 et RO2 sur la base du signal Ni.

Par exemple, le circuit 200 comprend un circuit 206 (bloc "BG CTRL") configuré pour recevoir le signal CMP et pour fournir au moins une tension déterminée par le signal CMP pour commander les grilles arrière de transistors PMOS et NMOS d'au moins un élément à retard d'au moins un des oscillateurs RO1 et RO2.

Dans le mode de réalisation de la figure 2, le circuit 200, par exemple le circuit 206, est configuré pour commander les grilles arrière de transistors PMOS et NMOS d'au moins un élément à retard de l'oscillateur RO1, les grilles arrière des transistors de l'oscillateur RO2 étant polarisées par des tensions fixes. Dit autrement, le circuit 200 est configuré pour ne commander que la fréquence de l'oscillateur RO1.

Selon un mode de réalisation, le circuit 200, par exemple le circuit 206, est configuré pour commander les grilles arrière de tous les transistors de l'oscillateur RO1, en fournissant une tension de commande VBG1 aux grilles arrière de tous les transistors PMOS de l'oscillateur RO1 et une tension de commande -VGB1 aux grilles arrière de tous les transistors NMOS de l'oscillateur RO1.

A titre d'exemple, les transistors PMOS, respectivement NMOS, sont disposés dans et sur une couche de silicium reposant sur une couche isolante reposant elle-même sur du silicium dopé de type N (ou puit de silicium N de l'anglais "N-well"), respectivement du silicium dopé de type P (ou puit de silicium P de l'anglais "P-well"), formant l'électrode de grille arrière de ces transistors. Dans cet exemple, la tension VBG1 est alors positive ou nulle et augmente, respectivement diminue, pour augmenter, respectivement diminuer, la fréquence de l'oscillateur RO1.

Dans un autre exemple, les transistors PMOS, respectivement NMOS, sont disposés dans et sur une couche de silicium reposant sur une couche isolante reposant elle-même sur du silicium dopé de type P (ou puit de silicium P de l'anglais "P-well"), respectivement du silicium dopé de type N (ou puit de silicium N de l'anglais "N-well"), formant l'électrode de grille arrière de ces transistors. Dans cet autre exemple, la tension VBG1 est alors négative ou nulle et augmente, respectivement diminue, en valeur absolue pour augmenter, respectivement diminuer, la fréquence de l'oscillateur RO1.

A titre d'exemple, le circuit 200 est en outre configuré pour fournir une tension de polarisation fixe VBG2f, respectivement -VBG2f, aux grilles arrière de tous les transistors PMOS, respectivement NMOS, de l'oscillateur RO2.

Dans la présente description, lorsqu'il est indiqué que le circuit 200 commande les grilles arrière de tous les transistors d'un oscillateur RO1 ou RO2, cela signifie de préférence que le circuit 200 commande les grilles arrière d'au moins tous les transistors des éléments à retard de la boucle fermée de l'oscillateur, c'est à dire des transistors de l'oscillateur ayant une tension de seuil influençant directement la fréquence des oscillations dans l'oscillateur.

A titre de variante de réalisation non illustrée, le circuit 200 est configuré pour commander la fréquence de l'oscillateur RO2 uniquement. La mise en œuvre de cette variante est à la portée de la personne du métier à partir de la description faite ci-dessus du cas où le circuit 200 commande la fréquence de l'oscillateur RO1 uniquement.

De préférence, la durée de comptage, qui dure ici N périodes du signal O2, est une durée glissante, ce qui permet au circuit 200 de commander de manière continue la fréquence d'au moins l'un des oscillateurs RO1 et RO2. A titre d'exemple, la durée de N périodes est dite glissante lorsque chaque durée de comptage de N périodes commence alors que la durée de comptage précédente de N périodes n'est pas terminée, c'est à dire lorsque chaque durée de comptage de N périodes recouvre en partie la durée de comptage précédente de N périodes et la durée de comptage suivante de N périodes. De manière alternative, la durée de comptage n'est pas une durée glissante, le compteur étant alors réinitialisé à chaque durée de comptage correspondant à N périodes du signal O2. A titre d'exemple, chaque durée de comptage de N périodes est dite non glissante lorsqu'elle ne recouvre pas, même en partie, les durées de comptage de N périodes précédente et suivante. A titre d'exemple, chaque durée de comptage non glissante de N périodes débute avec un front de type donné, par exemple un front montant, du signal Beat.

A titre d'exemple, le pas maximal avec lequel la période de l'oscillateur RO1 est modifiée par rapport à celle de l'oscillateur RO2, de sorte à pouvoir obtenir un écart de période entre les signaux O1 et O2 qui soit N fois plus faible que la période du signal O2, est égal à T/N avec T la valeur moyenne ou théorique de la période du signal O2. Par exemple, pour T égal à 2 ns, et N égal à 1000, la période de l'oscillateur RO1 est modifiée par rapport à celle de l'oscillateur avec un pas d'au plus 2 ps. La personne du métier sera en mesure de déterminer le pas correspondant sur les tensions de commande de la ou des grilles arrière des transistors commandés par le circuit 200.

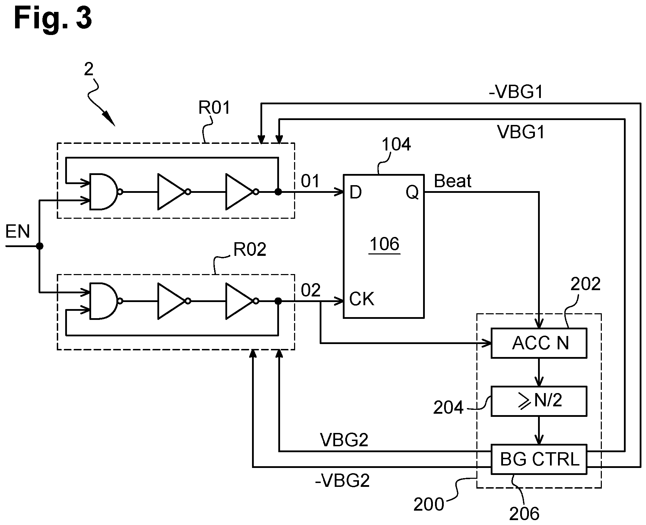

La figure 3 représente, sous la forme de blocs, une variante de réalisation du circuit 2 décrit en relation avec la figure 2. Le circuit 2 de la figure 3 présente de nombreuses similitudes avec celui de la figure 2, et seules les différences entre ces circuits sont ici mises en exergues.

En particulier, par rapport à ce qui a été décrit en relation avec la figure 2 où le circuit 200 commande la fréquence uniquement d'un seul des deux oscillateurs RO1 et RO2, dans la variante de la figure 3 le circuit 200 commande la fréquence des deux oscillateurs RO1 et RO2. Dit autrement, en figure 3, le circuit 200 est configuré pour commander, sur la base de l'écart entre les périodes des signaux O1 et O2, les grilles arrière de transistors NMOS et PMOS d'au moins un élément à retard de l'oscillateur RO1 et les grilles arrière de transistors NMOS et PMOS d'au moins un élément à retard de l'oscillateur RO2.

Selon un mode de réalisation, le circuit 200, par exemple le circuit 206 est configuré pour commander les grilles arrière de tous les transistors de l'oscillateur RO1, par exemple en fournissant une tension de commande VBG1 aux grilles arrière de tous les transistors PMOS de l'oscillateur RO1 et une tension de commande -VBG1 aux grilles arrière de tous les transistors NMOS de l'oscillateur RO1, ainsi que tous les transistors de l'oscillateur RO2, par exemple en fournissant une tension VBG2 aux grilles arrière de tous les transistors NMOS de l'oscillateur RO2 et une même tension - VBG2 à tous les transistors PMOS de l'oscillateur RO2. Les tensions VBG1 et -VBG1 ont une même valeur absolue mais des polarités opposées et les tensions VBG2 et -VBG2 ont une même valeur absolue mais des polarités opposées.

A titre d'exemple, la tension VBG2 est égale à la tension VBG1, de sorte qu'une variation de la tension VBG1 entrainant une augmentation ou une réduction de la fréquence de l'oscillateur RO1 entraîne respectivement une diminution ou une augmentation de la fréquence de l'oscillateur RO2. Toutefois, la personne du métier sera en mesure de prévoir des mises en œuvre où la tension VBG2 est différente de la tension VBG1 et/ou une partie seulement des transistors de l'oscillateur RO1 et de l'oscillateur RO2 sont commandés par le circuit 200.

Par rapport au circuit 2 de la figure 2 dans lequel un seul oscillateur RO1 ou RO2 est commandé par le circuit 200, le circuit 2 de la figure 3 est moins précis en ce qui concerne le réglage de la fréquence de l'oscillateur RO1 par rapport à celle de l'oscillateur RO2, du fait que les deux oscillateurs RO1 et RO2 sont commandés simultanément par le circuit 200.

Des exemples de modes de réalisation dans lesquels le circuit 200 commande l'oscillateur RO1 et/ou l'oscillateur RO2 en utilisant le signal Beat et un compteur pour obtenir une indication de l'écart de périodes entre les deux signaux O1 et O2 ont été décrits en relation avec les figures 2 et 3.

Dans d'autres exemples de modes de réalisation, le circuit 200 utilise directement les signaux O1 et O2 pour obtenir une indication de l'écart de période entre ces deux signaux, par exemple au moyen d'un détecteur de fréquence de phase recevant ces deux signaux O1 et O2.

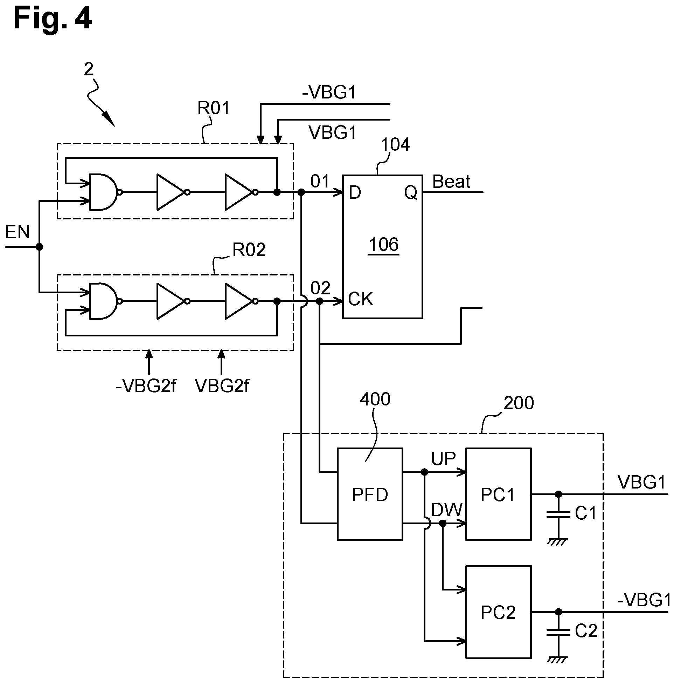

La figure 4 représente, sous la forme de blocs, un autre mode de réalisation du circuit 2. Le circuit 2 de la figure 4 comprend de nombreuses similitudes avec les circuits 2 décrits en relation avec les figures 2 et 3, et seules les différences entre ces circuits sont ici mises en exergue.

En particulier, le circuit 2 de la figure 4 diffère des circuits 2 décrits précédemment par la mise en œuvre de son circuit 200. En effet, en figure 4, le circuit 200 utilise directement les signaux O1 et O2 pour obtenir une indication de l'écart de période entre ces signaux O1 et O2. Ainsi, au lieu de recevoir les signaux Beat et O2 comme dans les circuits 200 précédemment décrits, en figure 4, le circuit 200 reçoit les signaux O1 et O2.

Selon un mode de réalisation, le circuit 200 comprend un détecteur de fréquence de phase 400 (bloc "PFD") recevant les signaux O1 et O2, et fournissant en sortie une indication de la valeur de l'écart de période entre les signaux O1 et O2. A titre d'exemple, le circuit 400 fournit une impulsion UP quand le signal O1 est en retard de phase par rapport au signal O2, l'impulsion UP ayant une durée représentative de, ou déterminée par, la valeur de l'écart de période entre les signaux O1 et O2, et une impulsion DW quand le signal O1 est en avance de phase par rapport au signal O2, l'impulsion DW ayant une durée représentative de, ou déterminée par, la valeur de l'écart de période entre les signaux O1 et O2.

Dans l'exemple de la figure 4, le circuit 200 est configuré pour commander la grille arrière de transistors PMOS et NMOS d'au moins un élément à retard de l'oscillateur RO1 seulement. Par exemple, le circuit 200 est configuré pour commander la grille arrière de tous les transistors PMOS et NMOS de l'oscillateur RO1, par exemple en fournissant une même tension VBG1 aux grilles arrière de tous les transistors PMOS de l'oscillateur RO1 et une même tension -VBG1 aux grilles arrière de tous les transistors NMOS de l'oscillateur RO1. De préférence, les tensions VB1 et -VBG1 ont une même valeur absolue mais une polarité (ou signe) opposée. Dans l'exemple de la figure 4, le circuit 200 ne commande pas la fréquence de l'oscillateur RO2, et les grilles arrière de tous les transistors PMOS, respectivement NMOS, de l'oscillateur RO2 reçoivent par exemple une même tension de polarisation constante VBG2f, respectivement -VBG2f.

Selon un mode de réalisation, le circuit 200 comprend au moins une pompe de charge PC1, PC2 commandée par le détecteur de fréquence de phase 400 et configurée pour fournir la tension de commande à chaque grille arrière commandée par le circuit 200. Par exemple, chaque pompe de charge PC1, PC2 est commandée par le détecteur de fréquence de phase 400 de sorte à charger et décharger une capacité C1, C2 connectée à sa sortie, une tension de commande de la grille arrière d'au moins un transistor de l'oscillateur RO1 étant disponible aux bornes de la capacité.

A titre d'exemple, comme cela est représenté en figure 4, le circuit 200 comprend une première pompe de charge PC1 commandée par le circuit 400 et une deuxième pompe de charge PC1 commandée par le circuit 400. La pompe de charge PC1 est configurée pour charger et décharger, sous le contrôle du circuit 400, une capacité C1 connectée sur sa sortie et aux bornes de laquelle est disponible la tension VBG1. La pompe de charge PC2 est configurée pour charger et décharger, sous le contrôle du circuit 400, une capacité C2 connectée sur sa sortie et aux bornes de laquelle est disponible la tension - VBG1.

La personne du métier est en mesure de dimensionner, chaque pompe de charge PC1, PC2 du circuit 200, les sources de courant (non représentées en figure 4) de la pompe de charge et la capacité connectée sur la sortie de cette pompe de charge, par exemple de sorte que les variations de la tension aux bornes de cette capacité permettent l'obtention d'un écart de périodes entre les signaux O1 et O2 qui soit au moins N fois plus faible que la période du signal O2.

La personne du métier est également en mesure d'adapter la description faite ci-dessus en relation avec la figure 4, qui correspond à un cas où le circuit 200 commande la fréquence de l'oscillateur RO1 uniquement, à d'autres cas où soit le circuit 200 commande la fréquence de l'oscillateur RO1 et de l'oscillateur RO2 simultanément, soit le circuit 200 commande la fréquence de l'oscillateur RO2 uniquement.

Dans les exemples de modes de réalisation décrits précédemment, les fronts du premier type du signal O2 sont des fronts de type montant. La personne du métier est en mesure d'adapter la description faite précédemment de ces exemples de modes de réalisation au cas où les fronts du premier type du signal O2 sont des fronts de type descendant.

Dans les exemples de modes de réalisation décrits ci-dessus en relation avec les figures 2 et 3, le compteur 202 est configuré pour compter le nombre de fois où le signal Beat est à l'état haut pendant une durée de N périodes du signal O2, c'est à dire pour mesurer la durée de la demi-période haute du signal Beat en nombre de périodes du signal O2. La personne du métier est en mesure d'adapter la description faite précédemment de ces exemples de modes de réalisation au cas où le compteur 202 est configuré pour compter le nombre de fois où le signal Beat est à l'état bas pendant une durée de N périodes du signal O2, c'est à dire pour mesurer la durée de la demi-période basse du signal Beat en nombre de périodes du signal O2.

Dans les exemples de modes de réalisation décrits précédemment, les oscillateurs RO1 et RO2 sont configurés pour recevoir un signal EN activant ou désactivant la propagation d'oscillation. La personne du métier est en mesure d'adapter la description faite précédemment de ces exemples de modes de réalisation au cas où la propagation d'oscillations dans les oscillateurs RO1 et RO2 n'est pas conditionnée par le signal EN, c'est à dire au cas où les oscillateurs ne reçoivent pas le signal EN.

En outre, dans les exemples de modes de réalisation décrits précédemment, les éléments à retard 100 des oscillateurs RO1 et RO2 sont des portes inverseuses (ou inverseurs). Toutefois, les oscillateurs RO1 et RO2 pourront être mis en œuvre avec tous types d'éléments à retard, par exemple avec des cellules logiques d'un FPGA.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Circuit (2) de génération de nombres aléatoires de type à oscillateur en anneau à échantillonnage corrélé comprenant :
un premier oscillateur en anneau (RO1) et un deuxième oscillateur en anneau (RO2) comprenant chacun des éléments à retard connectés en série en boucle fermée, les premier et deuxième oscillateurs (RO1, RO2) étant identiques et mis en œuvre en technologie Métal Oxyde Semiconducteur Complémentaire sur silicium sur isolant complétement déplété ;
un premier circuit (104) configuré pour échantillonner et mémoriser l'état d'une sortie (O1) du premier oscillateur (RO1) à une fréquence d'une sortie (O2) du deuxième oscillateur (RO2) et pour fournir un signal binaire (Beat) correspondant ; et
un deuxième circuit (200) configuré pour commander des grilles arrière de transistors PMOS et NMOS d'au moins un élément à retard d'au moins un des premier et deuxième oscillateurs (RO1, RO2), sur la base d'un écart de période entre les sorties (O1, O2) des premier et deuxième oscillateurs (RO1, RO2).

2. Circuit selon la revendication 1, dans lequel la commande des grilles arrière desdits transistors PMOS et NMOS dudit au moins un élément à retard est configurée pour augmenter une fréquence du premier oscillateur (RO1) par rapport à une fréquence du deuxième oscillateur (RO2) lorsque la fréquence de la sortie (O1) du premier oscillateur (RO1) est plus faible que la fréquence de la sortie (O2) du deuxième oscillateur (RO2), et pour diminuer la fréquence premier oscillateur (RO1) par rapport à la fréquence du deuxième oscillateur (RO2) lorsque la fréquence de la sortie (O1) du premier oscillateur (RO1) est plus grande que la fréquence de la sortie (02) du deuxième oscillateur (RO2).

3. Circuit selon la revendication 1 ou 2, dans lequel le deuxième circuit (200) est configuré pour commander les grilles arrière desdits transistors PMOS et NMOS dudit au moins un élément à retard de sorte à réduire l'écart de période.

4. Circuit selon l'une quelconque des revendications 1 à 3, dans lequel le deuxième circuit (200) est configuré pour commander les grilles arrière desdits transistors PMOS et NMOS dudit au moins un élément à retard de sorte que l'écart de période soit au moins N fois plus faible que la période du deuxième oscillateur (RO2), avec N un nombre déterminé pour qu'une contribution du bruit thermique soit prépondérante devant une contribution du bruit de quantification dans la gigue de la sortie (O2) du deuxième oscillateur (RO2).

5. Circuit selon la revendication 4, dans lequel N est supérieur ou égal à 1000, par exemple égal à 1000.

6. Circuit selon la revendication 4 ou 5, dans lequel le deuxième circuit (200) comprend un compteur (202) configuré pour compter, à une fréquence de la sortie (O2) du deuxième oscillateur (RO2), un nombre (Ni) de fois où ledit signal binaire (Beat) est à un premier état binaire pendant une durée de N périodes de la sortie (O2) du deuxième oscillateur (RO2).

7. Circuit selon la revendication 6, dans lequel ladite durée est une durée glissante.

8. Circuit selon la revendication 6 ou 7, dans lequel le deuxième circuit (200) comprend en outre un comparateur (204) configuré pour comparer ledit nombre (Ni) à une valeur égale à N/2.

9. Circuit selon la revendication 8, dans lequel le deuxième circuit (200) est configuré pour commander les grilles arrière desdits transistors PMOS et NMOS dudit au moins un élément à retard à partir d'un signal de sortie (CMP) du comparateur (204) indiquant le résultat de ladite comparaison.

10. Circuit selon l'une quelconque des revendications 1 à 5, dans lequel le deuxième circuit (200) comprend un détecteur de fréquence de phase (PFD) configuré pour recevoir les sorties (O1, O2) des premier et deuxième oscillateurs (RO1, RO2).

11. Circuit selon la revendication 10, dans lequel le circuit (2) de génération de nombres aléatoires comprend au moins une pompe de charge (PC1, PC2) commandée par le détecteur de fréquence de phase (PFD) et configurée pour charger et décharger une capacité (C1, C2) connectée à une sortie de ladite au moins une pompe de charge, une tension de commande (VBG1, -VBG1) des grilles arrière desdits transistors PMOS et NMOS dudit au moins un élément à retard étant disponible aux bornes de la capacité (C1, C2).

12. Circuit selon l'une quelconque des revendications 1 à 11, dans lequel le deuxième circuit (200) est configuré pour commander la grille arrière de chacun des transistors PMOS et NMOS d'un seul des premier et deuxième oscillateurs (RO1, RO2).

13. Circuit selon la revendication 12, dans lequel le deuxième circuit est configuré pour fournir une même première tension (VBG1) à la grille arrière de chacun des transistors PMOS dudit un seul des premier et deuxième oscillateurs (RO1, RO2), et une même deuxième tension (-VBG1) à la grille arrière de chacun des transistors NMOS dudit un seul des premier et deuxième oscillateurs (RO1, RO2).

14. Circuit selon l'une quelconque des revendications 1 à 11, dans lequel le deuxième circuit (200) est configuré pour commander la grille arrière de chacun des transistors de chacun des premier et deuxième oscillateurs (RO1, RO2).

15. Circuit selon la revendication 14, dans lequel le deuxième circuit (200) est configuré pour fournir une même première tension (VBG1) à la grille arrière de chacun des transistors PMOS du premier oscillateur (RO1), une même deuxième tension (-VBG1) à la grille arrière de chacun des transistors NMOS du premier oscillateur (RO1), une même troisième tension (-VBG2) à la grille arrière de chacun des transistors PMOS du deuxième oscillateur (RO2), et une même quatrième tension (VBG2) à la grille arrière de chacun des transistors NMOS du deuxième oscillateur (RO2).

## Patentansprüche

1. Zufallszahlen-Generatorschaltung in Form eines Ringoszillators mit korrelierter Abtastung (2), die Folgendes aufweist:
einen ersten Ringoszillator (RO1) und einen zweiten Ringoszillator (RO2), die jeweils Verzögerungselemente aufweisen, die in einer geschlossenen Schleife in Reihe geschaltet sind, wobei der erste und der zweite Oszillator (RO1, RO2) identisch sind und in einem komplementären Metalloxid-Halbleiter auf einer vollständig verarmten Silizium-auf-Isolator-Technologie implementiert sind;
eine erste Schaltung (104), konfiguriert zum Abtasten und Speichern des Zustands eines Ausgangs (O1) des ersten Oszillators (RO1) bei einer Frequenz eines Ausgangs (O2) des zweiten Oszillators (RO2) und zum Liefern eines entsprechenden Binärsignals (Beat); und
eine zweite Schaltung (200), konfiguriert zum Steuern von Back-Gates von PMOS-und NMOS-Transistoren von wenigstens einem Verzögerungselement von wenigstens einem der ersten und zweiten Oszillatoren (RO1, RO2), basierend auf einer Periodendifferenz zwischen den Ausgängen (O1, O2) der ersten und zweiten Oszillatoren (RO1, RO2).

2. Schaltung nach Anspruch 1, wobei die Steuerung der Back-Gates der PMOS- und NMOS-Transistoren des wenigstens einen Verzögerungselements konfiguriert ist zum Erhöhen einer Frequenz des ersten Oszillators (RO1) bezüglich einer Frequenz des zweiten Oszillators (RO2), wenn die Frequenz des Ausgangs (O1) des ersten Oszillators (RO1) niedriger ist als die Frequenz des Ausgangs (O2) des zweiten Oszillators (RO2), und zum Verringern der Frequenz des ersten Oszillators (RO1) bezüglich der Frequenz des zweiten Oszillators (RO2), wenn die Frequenz des Ausgangs des ersten Oszillators (RO1) größer ist als die Frequenz des Ausgangs (O2) des zweiten Oszillators (RO2).

3. Schaltung nach Anspruch 1 oder 2, wobei die zweite Schaltung (200) konfiguriert ist zum Steuern der Back-Gates der PMOS- und NMOS-Transistoren des wenigstens einen Verzögerungselements, um die Periodendifferenz zu verringern.

4. Schaltung nach einem der Ansprüche 1 bis 3, wobei die zweite Schaltung (200) konfiguriert ist zum Steuern der Back-Gates der PMOS- und NMOS-Transistoren des wenigstens einen Verzögerungselements, so dass die Periodendifferenz wenigstens N-mal kürzer ist als die Periode des zweiten Oszillators (RO2), wobei N eine Zahl ist, die so bestimmt ist, dass ein Beitrag des thermischen Rauschens überwiegt gegenüber einem Beitrag des Quantisierungsrauschens in dem Jitter des Ausgangs (O2) des zweiten Oszillators (RO2).

5. Schaltung nach Anspruch 4, wobei N größer oder gleich 1.000, zum Beispiel gleich 1.000, ist.

6. Schaltung nach Anspruch 4 oder 5, wobei die zweite Schaltung (200) einen Zähler (202) aufweist konfiguriert zum Zählen, bei einer Frequenz des Ausgangs (O2) des zweiten Oszillators (RO2), einer Anzahl (Ni) von Malen, wenn das binäre Signal (Beat) in einem ersten binären Zustand ist für eine Dauer von N Perioden des Ausgangs (O2) des zweiten Oszillators (RO2).

7. Schaltung nach Anspruch 6, wobei die Dauer eine gleitende Dauer ist.

8. Schaltung nach Anspruch 6 oder 7, wobei die zweite Schaltung (200) ferner einen Komparator (204) aufweist konfiguriert zum Vergleichen der Zahl (Ni) mit einem Wert gleich N/2.

9. Schaltung nach Anspruch 8, wobei die zweite Schaltung (200) konfiguriert ist zum Steuern der Back-Gates der PMOS- und NMOS-Transistoren des wenigstens einen Verzögerungselements basierend auf einem Ausgangssignal (CMP) des Komparators (204), das das Ergebnis des Vergleichs anzeigt.

10. Schaltung nach einem der Ansprüche 1 bis 5, wobei die zweite Schaltung (200) einen Phasenfrequenzdetektor (PFD) aufweist konfiguriert zum Empfangen der Ausgänge (O1, O2) des ersten und zweiten Oszillators (RO1, RO2).

11. Schaltung nach Anspruch 10, wobei die Zufallszahlen- Generatorschaltung (2) wenigstens eine Ladungspumpe (PC1, PC2) aufweist, die durch den Phasenfrequenzdetektor (PFD) gesteuert wird und konfiguriert ist zum Laden und Entladen eines kapazitiven Elements (C1, C2), das mit einem Ausgang der wenigstens einen Ladungspumpe verbunden ist, wobei eine Spannung (VBG1, - VBG1) zum Steuern der Back-Gates der PMOS- und NMOS- Transistoren des wenigstens einen Verzögerungselements über dem kapazitiven Element (C1, C2) verfügbar ist.

12. Schaltung nach einem der Ansprüche 1 bis 11, wobei die zweite Schaltung (200) konfiguriert ist zum Steuern des Back-Gates jedes der PMOS- und NMOS-Transistoren eines einzelnen des ersten und zweiten Oszillators (RO1, RO2).

13. Schaltung nach Anspruch 12, wobei die zweite Schaltung konfiguriert ist zum Liefern einer gleichen ersten Spannung (VBG1) an das Back-Gate jedes der PMOS-Transistoren des einen einzigen des ersten und zweiten Oszillators (RO1, RO2) und einer gleichen zweiten Spannung (-VBG1) an das Back-Gate jedes der NMOS-Transistoren des einen einzigen des ersten und zweiten Oszillators (RO1, RO2).

14. Schaltung nach einem der Ansprüche 1 bis 11, wobei die zweite Schaltung (200) konfiguriert ist zum Steuern des Back-Gates jedes der Transistoren jedes der ersten und zweiten Oszillatoren (RO1, RO2).

15. Schaltung nach Anspruch 14, wobei die zweite Schaltung (200) konfiguriert ist zum Liefern einer gleichen ersten Spannung (VBG1) an das Back-Gate jedes der PMOS-Transistoren des ersten Oszillators (RO1), einer gleichen zweiten Spannung (-VBG1) an das Back-Gate jedes der NMOS-Transistoren des ersten Oszillators (RO1), einer gleichen dritten Spannung (-VBG2) an das Back-Gate jedes der PMOS-Transistoren des zweiten Oszillators (RO2), und einer gleichen vierten Spannung (VBG2) an das Back-Gate jedes der NMOS-Transistoren des zweiten Oszillators (RO2).

## Claims

1. Random numbers generating circuit of correlated sampling ring oscillator type (2) comprising:
a first ring oscillator (RO1) and a second ring oscillator (RO2), each comprising delay elements series-connected in a closed loop, the first and second oscillators (RO1, RO2) being identical and implemented in complementary metal oxide semiconductor on fully depleted silicon-on-insulator technology;
a first circuit (104) configured to sample and store the state of an output (01) of the first oscillator (RO1) at a frequency of an output (O2) of the second oscillator (RO2) and to deliver a corresponding binary signal (Beat); and
a second circuit (200) configured to control back gates of PMOS and NMOS transistors of at least one delay element of at least one of the first and second oscillators (RO1, RO2), based on a period difference between the outputs (O1, O2) of the first and second oscillators (RO1, RO2).

2. Circuit according to claim 1, wherein the control of the back gates of said PMOS and NMOS transistors of said at least one delay element is configured to increase a frequency of the first oscillator (RO1) with respect to a frequency of the second oscillator (RO2) when the frequency of the output (01) of the first oscillator (RO1) is lower than the frequency of the output (O2) of the second oscillator (RO2), and to decrease the frequency of the first oscillator (RO1) with respect to the frequency of the second oscillator (RO2) when the frequency of the output (01) of the first oscillator (RO1) is greater than the frequency of the output (O2) of the second oscillator (RO2).

3. Circuit according to claim 1 or 2, wherein the second circuit (200) is configured to control the back gates of said PMOS and NMOS transistors of said at least one delay element to decrease the period difference.

4. Circuit according to any of claims 1 to 3, wherein the second circuit (200) is configured to control the back gates of said PMOS and NMOS transistors of said at least one delay element so that the period difference is at least N times shorter than the period of the second oscillator (RO2), with N a number determined so that a contribution of the thermal noise is preponderating over a contribution of the quantization noise in the jitter of the output (O2) of the second oscillator (RO2).

5. Circuit according to claim 4, wherein N is greater than or equal to 1,000, for example equal to 1,000.

6. Circuit according to claim 4 or 5, wherein the second circuit (200) comprises a counter (202) configured to count, at a frequency of the output (O2) of the second oscillator (RO2), a number (Ni) of times when said binary signal (Beat) is in a first binary state for a duration of N periods of the output (O2) of the second oscillator (RO2).

7. Circuit according to claim 6, wherein said duration is a sliding duration.

8. Circuit according to claim 6 or 7, wherein the second circuit (200) further comprises a comparator (204) configured to compare said number (Ni) with a value equal to N/2.

9. Circuit according to claim 8, wherein the second circuit (200) is configured to control the back gates of said PMOS and NMOS transistors of said at least one delay element based on an output signal (CMP) of the comparator (204) indicating the result of said comparison.

10. Circuit according to any of claims 1 to 5, wherein the second circuit (200) comprises a phase frequency detector (PFD) configured to receive the outputs (O1, O2) of the first and second oscillators (RO1, RO2).

11. Circuit according to claim 10, wherein the random number generation circuit (2) comprises at least one charge pump (PC1, PC2) controlled by the phase frequency detector (PFD) and configured to charge and discharge a capacitive element (C1, C2) connected to an output of said at least one charge pump, a voltage (VBG1, -VBG1) for controlling the back gates of said PMOS and NMOS transistors of said at least one delay element being available across the capacitive element (C1, C2).

12. Circuit according to any of claims 1 to 11, wherein the second circuit (200) is configured to control the back gate of each of the PMOS and NMOS transistors of a single one of the first and second oscillators (RO1, RO2).

13. Circuit according to claim 12, wherein the second circuit is configured to deliver a same first voltage (VBG1) to the back gate of each of the PMOS transistors of said a single one of the first and second oscillators (RO1, RO2), and a same second voltage (-VBG1) to the back gate of each of the NMOS transistors of said a single one of the first and second oscillators (RO1, RO2).

14. Circuit according to any of claims 1 to 11, wherein the second circuit (200) is configured to control the back gate of each of the transistors of each of the first and second oscillators (RO1, RO2).

15. Circuit according to claim 14, wherein the second circuit (200) is configured to deliver a same first voltage (VBG1) to the back gate of each of the PMOS transistors of the first oscillator (RO1), a same second voltage (-VBG1) to the back gate of each of the NMOS transistors of the first oscillator (RO1), a same third voltage (-VBG2) to the back gate of each of the PMOS transistors of the second oscillator (RO2), and a same fourth voltage (VBG2) to the back gate of each of the NMOS transistors of the second oscillator (RO2).
